# EUROPEAN PATENT APPLICATION

(11) **EP 4 306 404 A1**
(43) Date of publication of application: **17.01.2024**
(21) Application number: 23184916.7
(22) Date of filing: 12.07.2023
(51) Int. Cl.: B63H 5/125, B63H 21/17, B63J 3/02, B63H 21/38

(54) **ELECTROMOTIVE SAIL DRIVE AND SHIP**

(30) Priority: 14.07.2022 JP 2022113419; 05.07.2023 JP 2023110452
(71) Applicant: Yanmar Holdings Co., Ltd., Osaka-shi, Osaka (JP)
(72) Inventor: NAKANISHI, Takao, 1332 BS Almere-de Vaart (NL); VANDIJK, Gideon, 1332 BS Almere-de Vaart (NL); VANDEBURGT, Igor, 1332 BS Almere-de Vaart (NL); HATAYAMA, Kazuya, Musashi-machi (JP)
(74) Representative: Novagraaf International SA

(57) **Abstract**

[Problem] Provide an electromotive sail drive that, with a simple configuration, realizes cooling of an electromotive motor thereby to make it possible to drive the electromotive motor with output stable for a long time, and also provide a ship provided with the electromotive sail drive.

[Solution] An electromotive sail drive includes: an electromotive motor; a drive unit that is driven by the electromotive motor; and a pump that circulates, via the electromotive motor, a lubricant oil inside the drive unit.

## Description

### TECHNICAL FIELD

The present invention relates to an electromotive sail drive and a ship.

### BACKGROUND ART

When entering or leaving a port, a sail ship that sails using the wind power received by a sail drives a propulsion device (sail drive) by an engine thereby to cruise. The sail drive driven by the engine is disclosed, for example, in Patent Document 1.

### PRIOR ART DOCUMENT

### PATENT DOCUMENT

Patent Document 1: Japanese Unexamined Patent Application Publication No. 2008-223811

### SUMMARY OF INVENTION

### TECHNICAL PROBLEM

In recent years, environmental considerations have led to an attempt to use an electromotive motor, instead of the engine, thereby to drive the sail drive. Like the engine, the electromotive motor also generates heat as the electromotive motor is driven. Thus, so as to drive the electromotive motor with output stable for a long time period, it is necessary to devise a cool mechanism of the electromotive motor. In this case, using, for example, a heat exchanger as a cool mechanism of the electromotive motor is expensive. Thus, from a cost standpoint, it is desirable to cool the electromotive motor with a simple configuration.

The present invention has been made to solve the above problem; it is an object of the present invention to provide an electromotive sail drive that, with a simple configuration, realizes cooling of an electromotive motor thereby to make it possible to drive the electromotive motor with output stable for a long time, and also to provide a ship provided with the electromotive sail drive.

### SOLUTION TO PROBLEM

An electromotive sail drive according to an aspect of the present invention includes: an electromotive motor; a drive unit that is driven by the electromotive motor; and a pump that circulates, via the electromotive motor, a lubricant oil inside the drive unit.

A ship according to another aspect of the present invention includes the electromotive sail drive.

### ADVANTAGEOUS EFFECTS OF INVENTION

Cooling of an electromotive motor is realized with a simple configuration, making it possible to drive the electromotive motor with output stable for a long time period.

### BRIEF DESCRIPTION OF DRAWINGS

FIG. 1 is an illustration of a schematic configuration of a ship according to a first embodiment of the present invention.
FIG. 2 is a perspective view of a schematic configuration of an electromotive sail drive mounted on the ship.
FIG. 3 is a perspective view of the electromotive sail drive, with a lid body removed.
FIG. 4 is a schematic cross-sectional view of the electromotive sail drive.
FIG. 5 is a block diagram showing a schematic configuration of a motor control unit possessed by the electromotive sail drive.
FIG. 6 is a perspective view of the configuration of the lower part of the electromotive sail drive, exploded in the up-down direction.
FIG. 7 is a perspective view of an adapter possessed by the electromotive sail drive, viewed from one direction.
FIG. 8 is a perspective view of the adapter, viewed from another direction.
FIG. 9 is a perspective view of the configuration of an upper part of the electromotive sail drive, enlarged.
FIG. 10 is an illustration of a motor cool oil path of an electromotive motor possessed by the electromotive sail drive.
FIG. 11 is a schematic illustration of a heat sink oil path of a heat sink plate possessed by the motor control unit.
FIG. 12 is a perspective view of an upper part of an electromotive sail drive according to a modification, viewed from a right front side.
FIG. 13 is a perspective view of the upper part of the electromotive sail drive, viewed from a left front side.
FIG. 14 is an exploded perspective view of the upper part of the electromotive sail drive.
FIG. 15 is a perspective view of the upper part of the electromotive sail drive, viewed from the left front side, with a lid body omitted from illustration.
FIG. 16 is a perspective view illustrating a detailed configuration of the upper part of the electromotive sail drive.

### DESCRIPTION OF EMBODIMENTS

The following is a description of an embodiment of the present invention based on the drawings. Further, in the present specification, directions are defined as below for convenience. First, the bow side of a ship is defined as "front" and the stern side is defined as "back". Further, a transverse direction perpendicular to the front-back direction is defined as a left-right direction. In this case, the ship's left side seen when a helmsman aboard the ship faces forward is defined as "left" and the right side is defined as "right". Further, the upstream side of the gravity direction perpendicular to the front-back and left-right directions is defined as "up", and the downstream side of the same is defined as "down". In the drawings, the front direction is shown by F, the back direction by B, the left direction by L, the right direction by R, the upward direction by U, and the downward direction by D.

### [1. Ship]

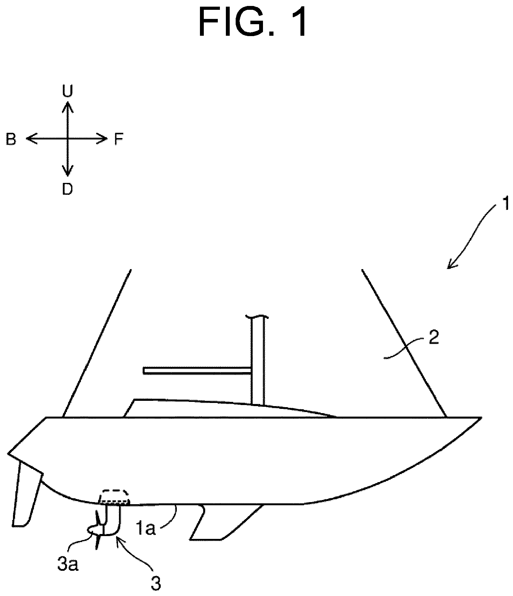

FIG. 1 is an illustration of a schematic configuration of a ship 1 according to the present embodiment. The ship 1 includes, for example, a sail ship. The sail ship sails by using the wind power received by a sail 2. Meanwhile, when entering or leaving a port, or in an emergency, an electromotive sail drive 3 installed on the sail ship is driven thereby to rotate a propeller 3a, thus the ship 1 cruises. That is, the ship 1 is provided with the electromotive sail drive 3. The electromotive sail drive 3 is mounted on a ship bottom 1a of the ship 1. The following is a detailed description of the electromotive sail drive 3.

### [2. Electromotive Sail Drive]

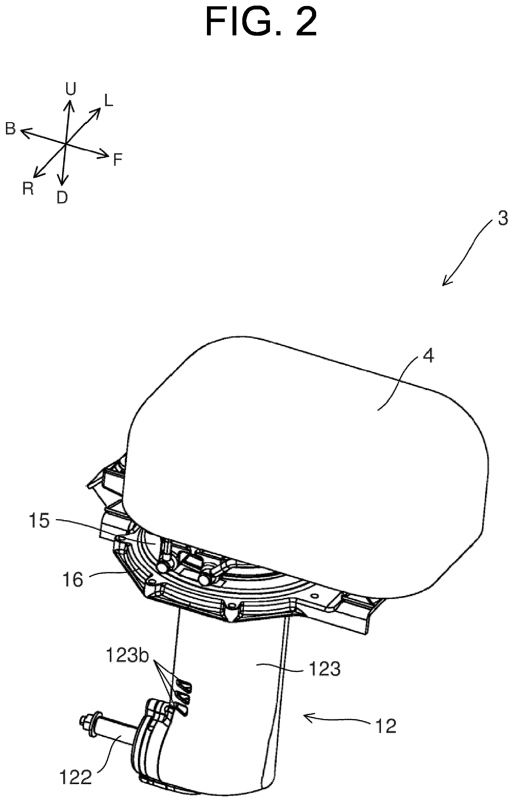

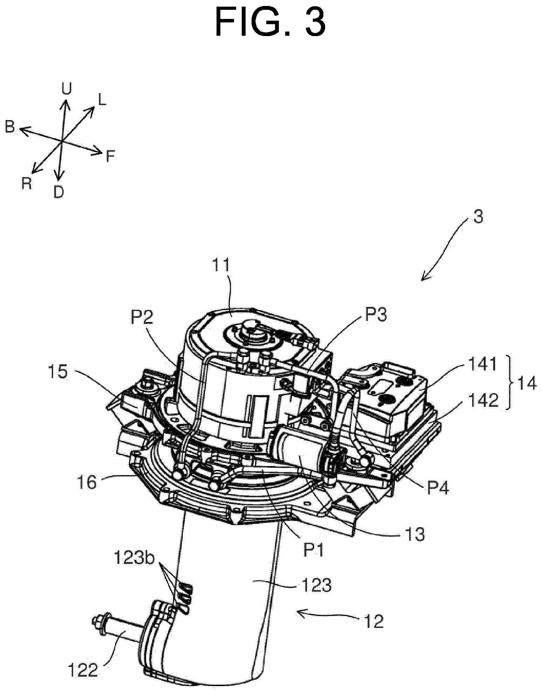

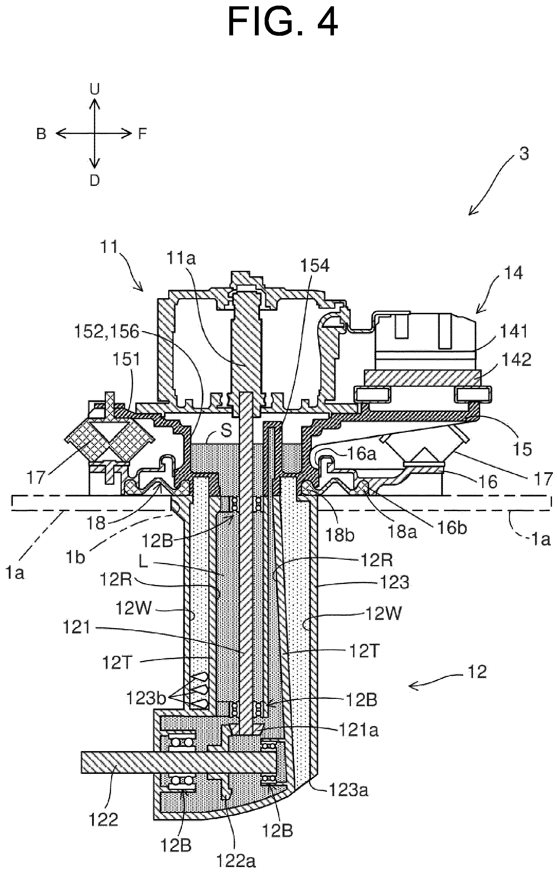

FIG. 2 is a perspective view of a schematic configuration of the electromotive sail drive 3. FIG. 3 is a perspective view of the electromotive sail drive 3 of FIG. 2, with a lid body 4 removed. FIG. 4 is a schematic cross-sectional view of the electromotive sail drive 3. Further, FIG. 2 and subsequent drawings omit an illustration of the propeller 3a in FIG. 1 for convenience.

As shown in FIGS. 2 to 4, the electromotive sail drive 3 has an electromotive motor 11, a drive unit 12, a pump 13, a motor control unit 14, an adapter 15, and a flange 16. The electromotive motor 11, the pump 13, and the motor control unit 14 are installed on the adapter 15. The lid body 4 (see FIG. 2) is mounted to the adapter 15, lidding the electromotive motor 11, the pump 13, and the motor control unit 14 from above.

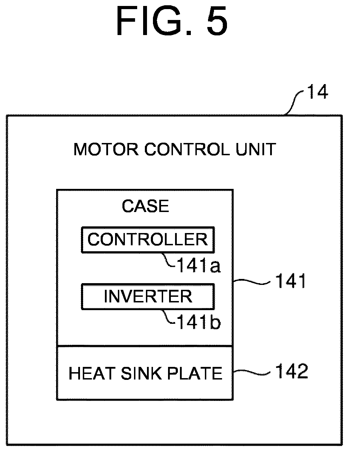

The electromotive motor 11 is driven by electric power supplied from a battery unit (not shown), which is installed on the ship 1 (see FIG. 1), via an inverter 141b (see FIG. 5) of the motor control unit 14. The electromotive motor 11 is positioned above the drive unit 12. A rotary shaft 11a of the electromotive motor 11 (see FIG. 4) is positioned along the up-down direction.

The drive unit 12 is a propulsion device that is driven by the electromotive motor 11 thereby to rotate the propeller 3a (see FIG. 1), thereby generating a propulsive force. As shown in FIG. 4, the drive unit 12 has a drive shaft 121 and a propeller shaft 122. In a housing 123 which extends in the up-down direction, the drive shaft 121 and the propeller shaft 122 are rotatably supported by a bearing 12B.

The drive shaft 121 is positioned extending in the up-down direction. The upper end of drive shaft 121 is positioned protruding upward from the housing 123. The upper end of the drive shaft 121 is connected with a rotary shaft 11a of the electromotive motor 11. A first gear 121a is mounted to the down end of the drive shaft 121. The first gear 121a includes a bevel gear, for example.

The propeller shaft 122 is positioned extending in the front-back direction. A second gear 122a is mounted to near the center of the propeller shaft 122 in the front-back direction. The second gear 122a includes a bevel gear, for example, and meshes with the first gear 121a. The back end of the propeller shaft 122 is positioned protruding backward from the housing 123. To the back end of the propeller shaft 122, the propeller 3a (see FIG. 1) is mounted.

Driving the electromotive motor 11 by the motor control unit 14 sends a rotary drive force of the electromotive motor 11 via the rotary shaft 11a, the drive shaft 121, the first gear 121a, and the second gear 122a to the propeller shaft 122, thus rotating the propeller shaft 122. This causes the propeller 3a to rotate thereby to generate a propulsive force, causing the ship 1 to cruise. In this case, the motor control unit 14 controls the rotary direction (forward/reverse) of the rotary shaft 11a of the electromotive motor 11, making it possible to switch the ship 1 proceeding forward and backward.

As shown in FIG. 4, the drive unit 12 has an oil chamber 12R in the housing 123. The oil chamber 12R chambers a lubricant oil L. The lubricant oil L is used so as to reduce the wear and friction in a part for contact of two relatively moving parts thereby to facilitate their relative motion. It is deemed that the above two members include, for example, the first gear 121a and the second gear 122a. Further, it is deemed that in the bearing 12B, the above two members include each of a combination of an inner ring and a ball, and a combination of an outer ring and a ball. That is, the first gear 121a, the second gear 122a, and the bearing 12B are positioned in the oil chamber 12R, thereby to be immersed in the lubricant oil L. For example, oil such as a gear oil can be used as the lubricant oil L.

The drive unit 12 has a water path 12W that is, in the housing 123, partitioned from the oil chamber 12R. More in detail, relative to the oil chamber 12R, the water path 12W is annularly positioned via a bulkhead 12T radially outward from the drive shaft 121. The water path 12W connects to a passing water port 123a provided in the front part of a bottom part of the housing 123. Further, the water path 12W connects to a communication hole 123b provided in the back part of a side wall of the housing 123. This allows seawater from the outside of the drive unit 12 to be taken in the water path 12W via one of the passing water port 123a and the communication hole 123b. Further, the seawater in the water path 12W is discharged to the outside of the drive unit 12 via another of the passing water port 123a and the communication hole 123b. That is, an intake port of the seawater to the water path 12W may be the passing water port 123a, or may be the communication hole 123b. Further, FIG. 2, etc. show the configuration of providing three communication holes 123b in the housing 123, but the number of communication holes 123b is not limited to three, and may be one, two, or four or more.

The pump 13 shown in FIG. 3 sucks in the lubricant oil L inside the drive unit 12 (especially oil chamber 12R), and circulates the lubricant oil L via the electromotive motor 11. The above pump 13 includes a hydraulic pump such as a gear pump. Further, the pump 13 may include a hydraulic pump other than the gear pump.

The motor control unit 14 controls the electromotive motor 11. FIG. 5 is an illustration of a schematic configuration of the motor control unit 14. The motor control unit 14 has a case 141 and a heat sink plate 142.

Inside the case 141, there are placed a controller 141a and the inverter 141b. That is, the motor control unit 14 includes the controller 141a and the inverter 141b. The controller 141a includes an electronic control unit that controls the inverter 141b. The above control unit is referred to as an ECU (Electronic Control Unit).

The inverter 141b supplies power to the electromotive motor 11. In more detail, the inverter 141b converts the DC voltage supplied from a battery (not shown) in the ship into 3-phase (U-, V-, and W-phase) AC voltage, and supplies the AC voltage to the electromotive motor 11 based on a rotation command output from the controller 141a. This rotates the electromotive motor 11.

The heat sink plate 142 includes a metal plate made of a metal (for example, aluminum), which has a high heat sink property, or an alloy thereof. The case 141 is placed on the heat sink plate 142. The controller 141a and the inverter 141b are placed inside the case 141; thus, it can be said that the controller 141a and the inverter 141b are placed on the heat sink plate 142.

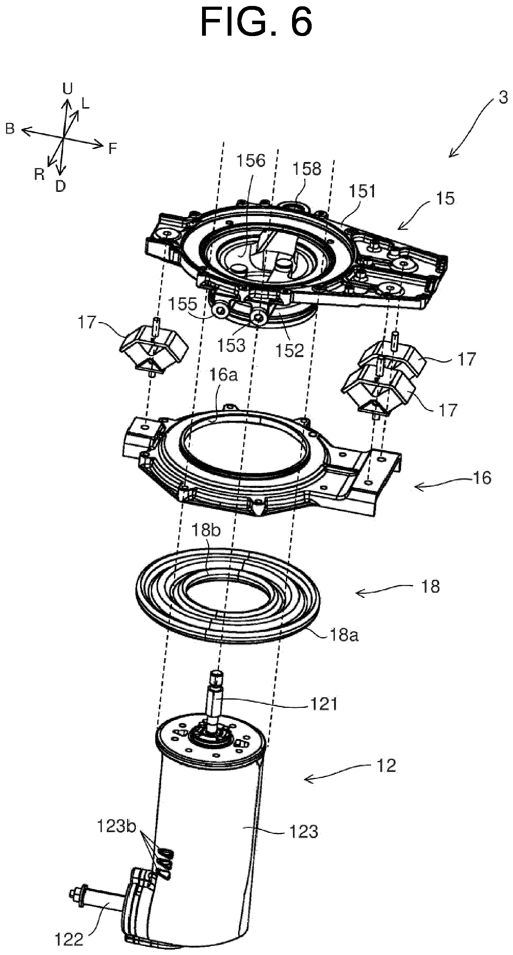

FIG. 6 is a perspective view of the configuration of the lower part of the electromotive sail drive 3, exploded in the up-down direction. The adapter 15 and the flange 16 are made of metal, for example. The adapter 15 has a support unit 151 and a recess unit 152. The support unit 151 supports the electromotive motor 11, the pump 13, the motor control unit 14, and the lid body 4 which are described above. The recess unit 152 is positioned in the center of the support unit 151, and has a downward depression. The recess unit 152 is inserted from above into an open part 16a positioned in the center of the flange 16, and is mounted by bolting, for example, to an upper part of the drive unit 12. That is, the electromotive sail drive 3 has the adapter 15 that is mounted to the drive unit 12.

The adapter 15 is supported via a vibration-proof member 17 to the flange 16. The vibration-proof member 17 includes a vibration-proof rubber, and is positioned around the open part 16a of the flange 16. FIG. 6 shows the three vibration-proof members 17, but the number of vibration-proof members 17 is not limited. Thus, the adapter 15 is supported to the flange 16 in a vibration-proof manner.

The flange 16 is mounted to the ship bottom 1a of the ship 1 (see FIG. 1) across an annular diaphragm 18 as a seal material. As shown in FIG. 4, a hole part 1b is formed in the ship bottom 1a, and the housing 123 of the drive unit 12 enters the hole part 1b. An outer peripheral part 18a of the diaphragm 18 enters and is held in a groove part 16b provided in the lower face of the flange 16. An inner peripheral part 18b of the diaphragm 18 is sandwiched in the up-down direction by the housing 123 and the adapter 15 (lower part of recess unit 152). This ensures sealing between the flange 16 and the ship bottom 1a when the flange 16 is mounted to the ship bottom 1a, thus reducing the risk of seawater entering the ship 1 via the hole part 1b.

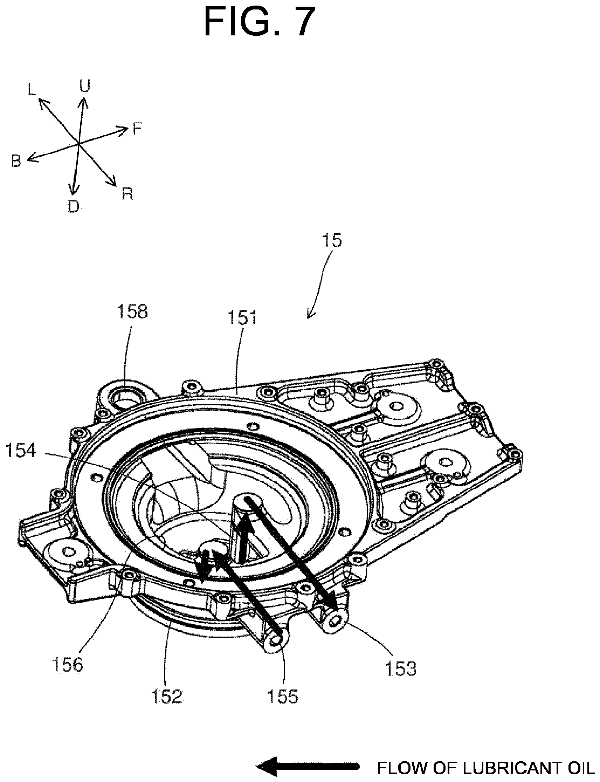

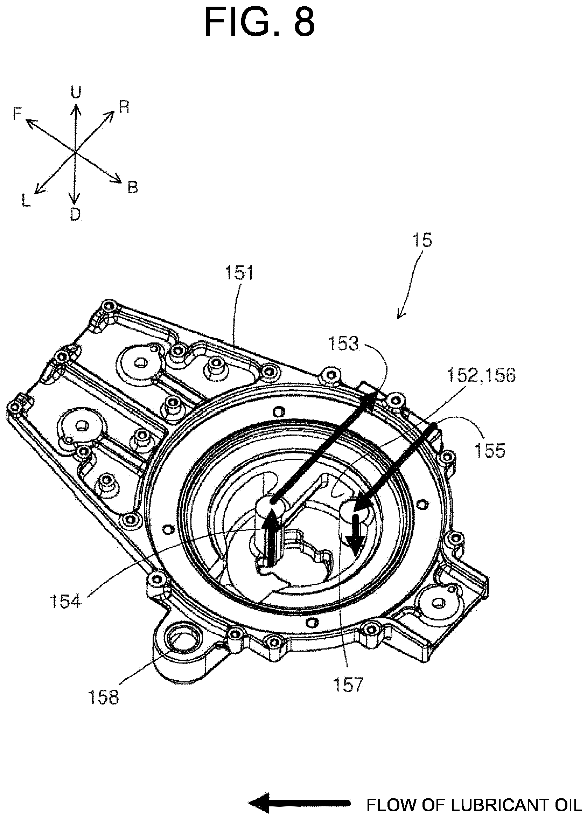

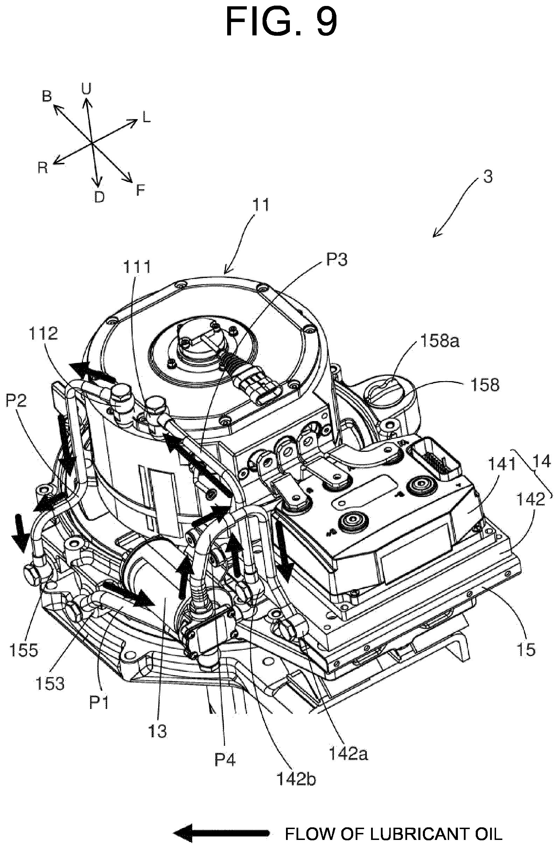

FIG. 7 is a perspective view of the adapter 15, viewed from one direction. FIG. 8 is a perspective view of the adapter 15, viewed from another direction. FIG. 9 is a perspective view of the configuration of the upper part of the electromotive sail drive 3, enlarged. In FIG. 7 and subsequent drawings, the lubricant oil L's flow described below is indicated by a bold arrow, for convenience. The adapter 15 has a first connection port 153, a connection pipe 154, a second connection port 155, and a lubricant oil receiving unit 156.

The first connection port 153 is a connection port that is connected via a first piping P1 with the pump 13. The first connection port 153 is positioned in the right side part of the support unit 151 of the adapter 15. The connection pipe 154 is a pipe that connects the first connection port 153 with the oil chamber 12R (see FIG. 4) of the drive unit 12. The connection pipe 154 extends from the first connection port 153 to the left, and then bends downward to the oil chamber 12R. The second connection port 155 is a connection port that is connected via the second piping P2 with the electromotive motor 11. The second connection port 155 is positioned in the right side part of the support unit 151 of the adapter 15, alongside the first connection port 153 in the front-back direction. The lubricant oil receiving unit 156 is formed by the inner face of the recess unit 152 of the adapter 15, and communicates with the oil chamber 12R of the drive unit 12. Positioned in the lubricant oil receiving unit 156 is a discharge pipe 157 (see FIG. 8) that is connected with the second connection port 155.

The description of the electromotive motor 11 and motor control unit 14 is to be supplemented. As shown in FIG. 9, the electromotive motor 11 has a first motor connection unit 111 and a second motor connection unit 112. The first motor connection unit 111 is a connection port to which the third piping P3 is connected, and is positioned protruding upward from the upper face of the electromotive motor 11. The second motor connection unit 112 is a connection port to which the second piping P2 is connected, and is positioned protruding upward from the upper face of the electromotive motor 11 and is positioned alongside the first motor connection unit 111.

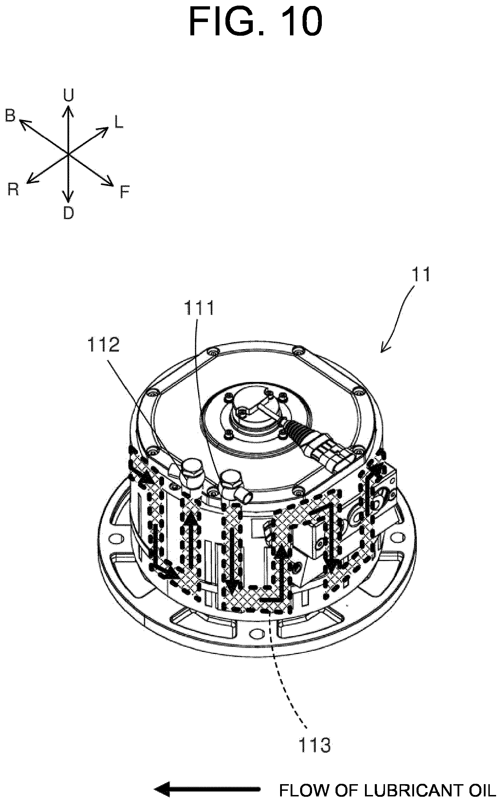

Inside the electromotive motor 11, a motor cool oil path 113 is formed through which the lubricant oil L passes, as shown in FIG. 10. Inside the electromotive motor 11, one end part of the motor cool oil path 113 is connected with the first motor connection unit 111, and the other end part is connected with the second motor connection unit 112. The motor cool oil path 113 is so formed as to proceed in a circumferential direction, from the first motor connection unit 111 toward the second motor connection unit 112, in a manner to fold up and down inside the electromotive motor 11. Further, the form of the motor cool oil path 113 inside the electromotive motor 11 is not limited to the example in FIG. 10.

Further, as shown in FIG. 9, the heat sink plate 142 of the motor control unit 14 has a first heat sink connection unit 142a and a second heat sink connection unit 142b. The first heat sink connection unit 142a is a connection port to which a fourth piping P4 is connected, and is provided on the right side face of the heat sink plate 142. Further, the fourth piping P4 is also connected with the pump 13. The second heat sink connection unit 142b is a connection port to which a third piping P3 is connected, and is provided alongside the first heat sink connection unit 142a on the right side face of the heat sink plate 142.

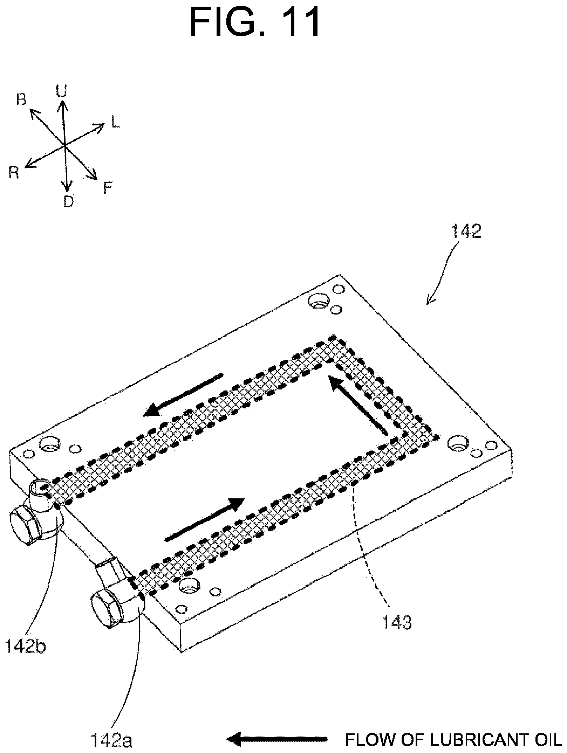

Inside the heat sink plate 142, there is formed the heat sink oil path 143 through which the lubricant oil L passes, as shown in FIG. 11. Inside the heat sink plate 142, one end part of the heat sink oil path 143 is connected with the first heat sink connection unit 142a, and the other end part is connected with the second heat sink connection unit 142b. The heat sink oil path 143 is formed in a U-shape extending inside the heat sink plate 142 from the first heat sink connection unit 142a toward the second heat sink connection unit 142b. Further, the form of the heat sink oil path 143 inside the heat sink plate 142 is not limited to the example shown in FIG. 11.

In the above configuration, driving the pump 13 causes the lubricant oil L in the oil chamber 12R of drive unit 12 to flow along arrow paths shown in FIGS. 7 to 11. That is, driving the pump 13 sucks up the lubricant oil L in the oil chamber 12R via the connection pipe 154 of the adapter 15 shown in FIGS. 4 and 7, and sends the lubricant oil L to the pump 13 through the first connection port 153 and the first piping P1 in that order. Then, the lubricant oil L is discharged from the pump 13 to the fourth piping P4, and then enters the heat sink oil path 143 from the first heat sink connection unit 142a of the heat sink plate 142 of the motor control unit 14, flowing through the heat sink oil path 143. The lubricant oil L having flowed through the heat sink oil path 143 is discharged from the second heat sink connection unit 142b to the third piping P3.

The lubricant oil L discharged to the third piping P3 enters the motor cool oil path 113 from the first motor connection unit 111 of the electromotive motor 11, flows through the motor cool oil path 113, and then is discharged from the second motor connection unit 112 to the second piping P2. The lubricant oil L discharged to the second piping P2 flows from the second connection port 155 of the adapter 15 to the discharge pipe 157 in the lubricant oil receiving unit 156, and is discharged to above an oil level S (see FIG. 4) of the lubricant oil L received in the lubricant oil receiving unit 156. The lubricant oil receiving unit 156 of the adapter 15 communicates with the oil chamber 12R of the drive unit 12; thus, the lubricant oil L in the oil chamber 12R is sucked up via the connection pipe 154 of the adapter 15 by the drive of the pump 13, and at the same time the lubricant oil L discharged from the discharge pipe 157 to the lubricant oil receiving unit 156 enters the oil chamber 12R of the drive unit 12. Thereafter, the above flow of the lubricant oil L is repeated. That is, the lubricant oil L inside the drive unit 12 flows in circulation via the pump 13, the motor control unit 14, and the electromotive motor 11.

The lubricant oil L inside the drive unit 12 is cooled by the low temperature seawater that is taken into the water path 12W inside the drive unit 12. Thus, the pump 13 circulates the lubricant oil L inside the drive unit 12 via the electromotive motor 11, thereby making it possible to cool the electromotive motor 11. This allows the electromotive motor 11 to be driven with the output stable for a long time period. Further, the fluid (lubricant oil L) used for lubrication inside the drive unit 12 is used as a cool medium of the electromotive motor 11; thus, there is no need to otherwise prepare a dedicated cool medium and cool mechanism (for example, heat exchanger) to cool the electromotive motor 11. As a result, cooling of the electromotive motor 11 can be realized with a simple configuration. That is, according to the above configuration, cooling of the electromotive motor 11 is realized with a simple configuration, making it possible to drive the electromotive motor 11 with the output stable for a long time.

In particular, from the viewpoint of securely realizing the cooling of the electromotive motor 11 by the lubricant oil L, it is desirable that the electromotive motor 11 should have the motor cool oil path 113 through which the lubricant oil L (supplied from the drive unit 12) flows.

From the viewpoint of effectively using the lubricant oil L inside the drive unit 12 also as a cool medium of the motor control unit 14, it is desirable that the pump 13 should circulate the lubricant oil L via the motor control unit 14, as shown in FIG. 9.

By the way, the motor control unit 14, due to including the controller 141a, has an allowable temperature (heat resistance temperature) lower than that of the electromotive motor 11. Thus, it is desirable to supply the lubricant oil L to the motor control unit 14 while the lubricant oil L is cold (before temperature increase) thereby to efficiently (with priority) cool the motor control unit 14. In this respect, supplying the lubricant oil L to the electromotive motor 11 prior to the motor control unit 14 thereby to cool the electromotive motor 11, for example, means supplying, to the motor control unit 14, the lubricant oil L after having absorbed the heat from the electromotive motor 11 (the lubricant oil L having the increased temperature), thus making it difficult to efficiently cool the motor control unit 14.

From the viewpoint of efficiently cooling, with the low-temperature lubricant oil L, the motor control unit 14 having the low allowable temperature; it is desirable that in the oil path (including first piping P1, fourth piping P4, and third piping P3) where the lubricant oil L flows from the drive unit 12 toward the electromotive motor 11, the positional relation among the pump 13, the motor control unit 14, and the electromotive motor 11 is set as in the present embodiment, thereby to supply the low temperature lubricant oil L to the motor control unit 14 prior to the electromotive motor 11. That is, as shown in FIG. 9; it is desirable that in the above oil path, the pump 13 should be positioned on an upstream side of the electromotive motor 11 in the flow direction of the lubricant oil L, and the motor control unit 14 should be positioned between the pump 13 and the electromotive motor 11.

The controller 141a and the inverter 141b, at the time of the driving of the electromotive motor 11, generate heat and become hot. In the configuration in which the motor control unit 14 includes the controller 141a and the inverter 141b as in the present embodiment, supplying the lubricant oil L to the motor control unit 14 can cool the controller 141a and the inverter 141b. Thus, the configuration of the present embodiment, in which the pump 13 circulates the lubricant oil L via the motor control unit 14 and the electromotive motor 11, is very effective in the configuration in which the motor control unit 14 includes the controller 141a and the like.

Further, to ensure that the controller 141a and the inverter 141b are cooled, it is very effective to cool, by the lubricant oil L, the heat sink plate 142 in which the controller 141a and the inverter 141b are placed. In this respect, it is desirable for the heat sink plate 142 to have the heat sink oil path 143 through which the lubricant oil L flows, as in the present embodiment.

From the viewpoint that the electromotive sail drive 3 can be handled as a single unit, it is desirable to create the configuration in which the electromotive motor 11, the motor control unit 14, and the pump 13 are installed together in the adapter 15 and the entire adapter 15 is mounted to the drive unit 12, as in the present embodiment.

So as to return the lubricant oil L, which was used for cooling the electromotive motor 11, to the inside of the drive unit 12 thereby to cool (by seawater) the lubricant oil L, and to take out the cooled lubricant oil L by the pump 13 and to reuse the lubricant oil L for cooling the electromotive motor 11, etc., it is desirable to secure, in the adapter 15 in which the electromotive motor 11, etc. is installed and which is mounted to the drive unit 12, the oil path for the lubricant oil L to pass through. From the viewpoint of securing the above oil path, it is desirable to create the configuration in which the adapter 15 has the first connection port 153, the connection pipe 154, the second connection port 155, and the lubricant oil receiving unit 156 which are described above.

By the way, filling the lubricant oil receiving unit 156 with the lubricant oil L (no space in the lubricant oil receiving unit 156), for example, makes it necessary, when the lubricant oil L expands due to the heat of the electromotive motor 11, to otherwise set, in the oil path outside the drive unit 12, a structural part having a space to absorb the thermal expansion of the lubricant oil L.

In the present embodiment, as shown in FIG. 4; in the adapter 15, the lubricant oil L is received in a part of the lubricant oil receiving unit 156. That is, the lubricant oil L does not fill the entirety of the lubricant oil receiving unit 156. With the above configuration; in the lubricant oil receiving unit 156, the remaining part (the space above the oil level S) in which lubricant oil L is not present can be used as the space to absorb the thermal expansion of the lubricant oil L, making it possible to easily take an action to the volume fluctuation attributable to thermal expansion of the lubricant oil L. Thus, it is no longer necessary to otherwise provide, in the oil path outside the drive unit 12, for example, the above structural part dedicated to absorbing the thermal expansion of the lubricant oil L.

To ensure that the lubricant oil L inside the drive unit 12 is cooled by seawater, it is desirable to take cold seawater via an intake port into the drive unit 12 thereby to cool, with the cold seawater, the lubricant oil L in the oil chamber 12R. In this respect, as shown in FIG. 4, it is desirable to create the configuration in which the drive unit 12 has the water path 12W partitioned (via bulkhead 12T) from the oil chamber 12R, and the water path 12W connects with the intake port of the seawater. The above intake port may include the passing water port 123a or the communication hole 123b, as described above.

Further, the drive unit 12 may be configured without the internal water path 12W inside. That is, the chamber that is inside the drive unit 12 and that is filled with the fluid may be only the oil chamber 12R. In this case, the housing 123 of the drive unit 12 is included in the side wall (outer wall) of the oil chamber 12R. In the above configuration, the lubricant oil L inside the oil chamber 12R is cooled by the surrounding seawater that is partitioned via the metal housing 123. Thus, even when the drive unit 12 is so configured as to be free from the water path 12W inside, circulating, by the pump 13, the lubricant oil L inside the drive unit 12 via the electromotive motor 11, etc. can cool the electromotive motor 11, etc.

As shown in FIGS. 7 to 9, the adapter 15 further has an oil supply port 158. The oil supply port 158 communicates with the lubricant oil receiving unit 156 (see FIG. 7). As shown in FIG. 9, a lid 158a is fitted to the oil supply port 158, but the lid 158a is omitted from FIGS. 7 and 8.

With the above configuration, at a proper time, such as during factory shipment of the electromotive sail drive 3, delivery to a distributor or customer, maintenance, etc., the lid 158a of the adapter 15 is removed and the lubricant oil L is poured from the oil supply port 158 into the lubricant oil receiving unit 156, making it possible to fill or replenish the lubricant oil L in the drive unit 12. In this way, the configuration in which the adapter 15 has the oil supply port 158 can fill or replenish the lubricant oil L via the oil supply port 158 at the proper timing, thus improving convenience.

Further, on the downstream side of the pump 13, there may be provided a pipe that branches off from the fourth piping P4 (see FIG. 9) and is dedicated to taking out the lubricant oil L inside the drive unit 12. It is also possible to periodically replace the lubricant oil L by driving the pump 13 during maintenance and taking out, via the pipe, the lubricant oil L inside the drive unit 12.

### [3. Modification]

The following is a detailed description of the modification of the electromotive sail drive 3 of the present embodiment. In the electromotive sail drive 3 of the modification, the basic configuration for cooling the electromotive motor 11, including the oil path through which the lubricant oil L flows and the order in which the lubricant oil L flows, is the same as that of the electromotive sail drive 3 shown in FIGS. 2 to 11. However, the electromotive sail drive 3 of the modification is different from the electromotive sail drive 3 shown in FIG. 2 and the like in a configuration of the lid body 4. Hereinafter, the configuration of the lid body 4 of the electromotive sail drive 3 of the modification will be described.

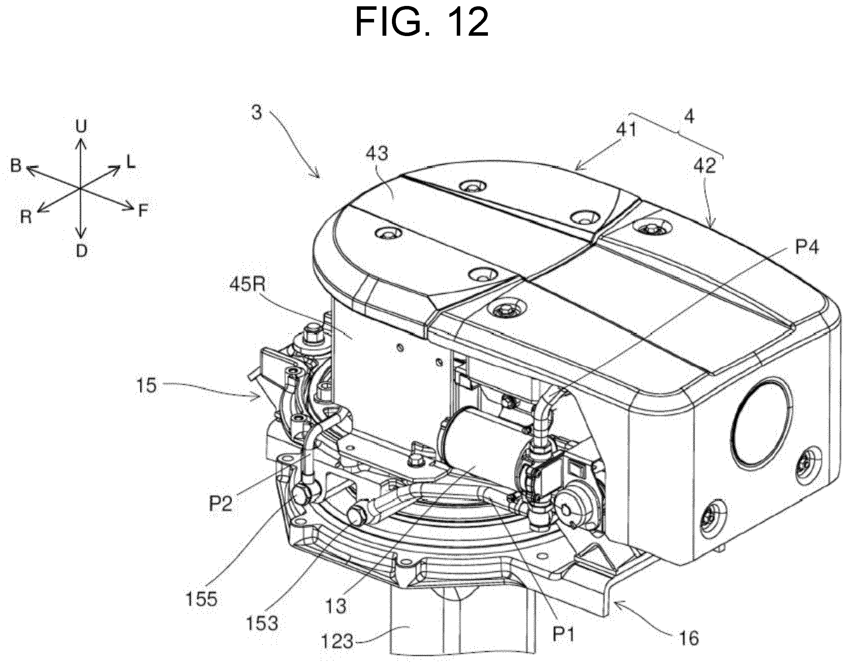

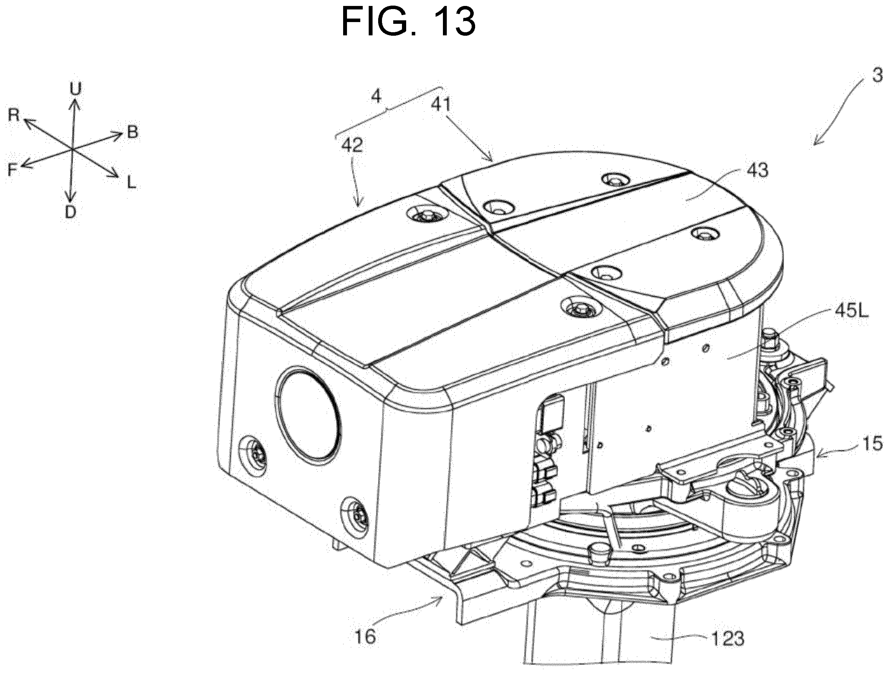

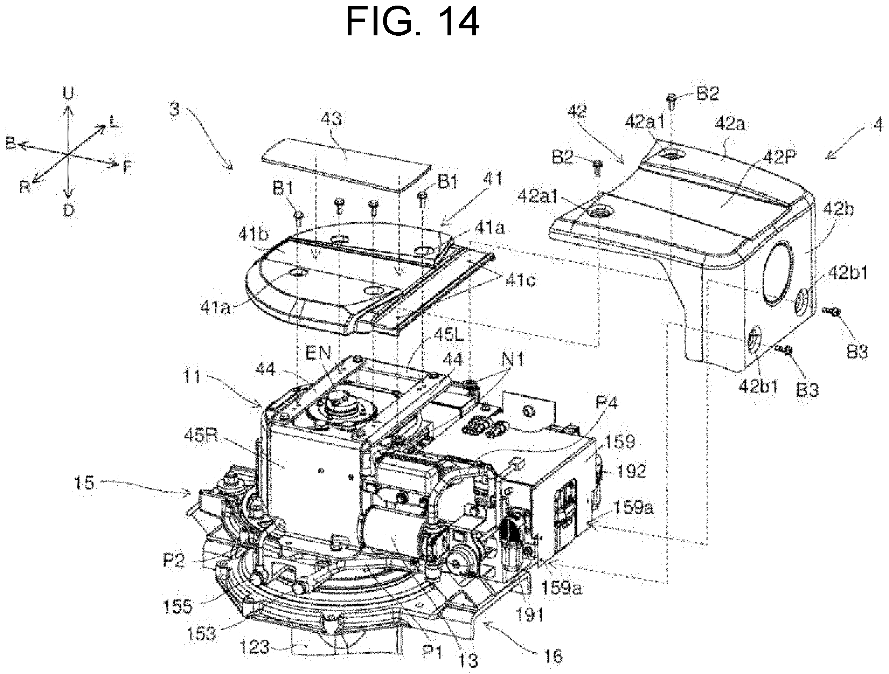

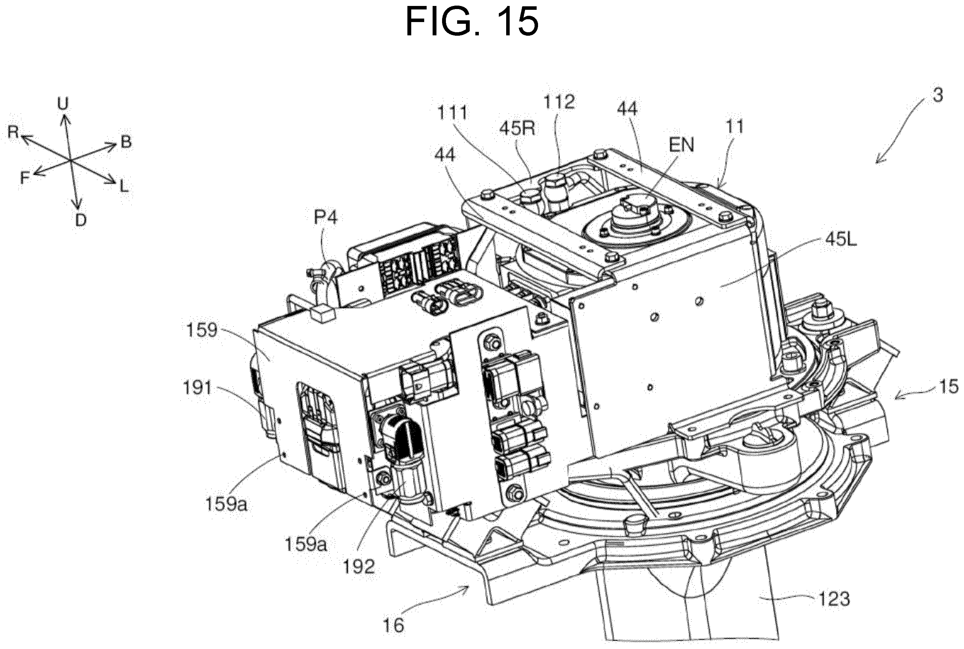

FIG. 12 is a perspective view of an upper part of the electromotive sail drive 3 according to the modification, viewed from a right front side. FIG. 13 is a perspective view of the upper part of the electromotive sail drive 3, viewed from a left front side. FIG. 14 is an exploded perspective view of the upper part of the electromotive sail drive 3. FIG. 15 is a perspective view of the upper part of the electromotive sail drive 3, viewed from the left front side, with the lid body 4 omitted from illustration.

The lid body 4 of the electromotive sail drive 3 may include a single cover as shown in FIG. 2, or may include a plurality of covers as shown in FIGS. 12 to 14. In the example of FIG. 12 and the like, the lid body 4 includes a first cover 41 and a second cover 42. The lid body 4 may include three or more covers.

### (3-1. First Cover)

The first cover 41 is made of, for example, a metal plate, and is provided to reinforce the lid body 4. The metal constituting the metal plate is, for example, aluminum. Thus, the first cover 41 can be easily manufactured by aluminum casting. The first cover 41 may be made of another metal such as stainless steel. As shown in FIG. 14, the first cover 41 has insertion holes 41a for inserting first bolts B1. In the first cover 41, four insertion holes 41a are provided, but the number of the insertion holes 41a is not particularly limited. The first cover 41 is located above the electromotive motor 11.

A groove part 41b is formed in a central part in the left-right direction of the first cover 41. The groove part 41b is formed so as to extend in the front-back direction. Due to the existence of the groove part 41b, a step is formed on a surface of the first cover 41. This increases the rigidity (in particular, bending rigidity) of the first cover 41. A resin plate 43 is fitted into the groove part 41b, whereby the surface (upper face) of the first cover 41 is formed to be flush in appearance. Note that it is not always necessary to provide the resin plate 43.

The first cover 41 is fixed to mounting stays 44 extending in the left-right direction by first bolts B1. Two mounting stays 44 are provided at an interval in the front-back direction. The respective mounting stays 44 are bolted to upper parts of left and right side walls 45R and 45L mounted on the adapter 15, and are bridged in the left-right direction. Therefore, the first cover 41 is supported by the adapter 15 via the mounting stays 44 and the left and right side walls 45R and 45L.

In this way, the first cover 41 is positioned above the electromotive motor 11 and is supported by the adapter 15 via the mounting stays 44 and the like, so that the electromotive motor 11 can be protected from external force. For example, even in a case where a passenger on board the ship 1 (see FIG. 1) tries to access the electromotive sail drive 3 for a purpose of maintenance and accidentally steps on the electromotive sail drive 3 with his/her foot, the first cover 41 receives a pressing force at the time of stepping on. This reduces the risk of damage to the electromotive motor 11.

An encoder EN for detecting a rotational speed of an output shaft of the electromotive motor 11 is provided on an upper part of the electromotive motor 11. A wire (not shown) for leading an output signal of the encoder EN to the controller 141a (see FIG. 5) is drawn out from the encoder EN. In addition, the first motor connection unit 111 and the second motor connection unit 112 of the electromotive motor 11 are also positioned on the upper part of the electromotive motor 11 (see FIG. 15). Even when the passenger accidentally steps on the electromotive sail drive 3 from above with his/her foot, the first cover 41 receives the pressing force, so that the risk that the wire is detached from the encoder EN is reduced. Furthermore, the risk of breakage of the first motor connection unit 111 and the second motor connection unit 112 is also reduced.

A rear side of the electromotive motor 11 is not covered by the first cover 41 and other members and is exposed to the outside (see FIGS. 14 and 15). Thus, the heat radiation performance of the electromotive motor 11 is improved.

### (3-2. Second Cover)

The second cover 42 is made of, for example, resin such as polycarbonate, but may be made of another resin such as acrylic. In addition, the second cover 42 may be made of metal similarly to the first cover 41. That is, at least a part of the lid body 4 may be a metal cover. Whether the second cover 42 is made of resin or metal may be appropriately selected according to, for example, cost. The second cover 42 is positioned in front of the first cover 41 and covers the motor control unit 14 (see FIG. 3 and the like).

As shown in FIG. 14, the second cover 42 has an upper cover 42a and a front cover 42b. The upper cover 42a is positioned above the motor control unit 14. The front cover 42b extends in the left-right direction from the front of the motor control unit 14, and both end parts thereof in the left-right direction are formed so as to extend further backward. The front cover 42b is connected to a part of a peripheral edge of the upper cover 42a.

In a rear part of the upper cover 42a, first through holes 42a1 penetrating in the up-down direction are formed side by side in the left-right direction. In the front cover 42b, second through holes 42b1 penetrating in the front-back direction are formed side by side in the left-right direction. Second bolt B2 are inserted into the first through holes 42a1, further inserted into mounting holes 41c formed in the front part of the first cover 41, and fastened to nuts N1 on a back face side. Further, third bolts B3 are inserted into the second through holes 42b1 and screwed into open parts 159a of the mounting cover 159 mounted on the adapter 15. Thus, the second cover 42 is mounted on both the first cover 41 and the adapter 15. Although various types of harnesses are routed on the upper face of the mounting cover 159, the harnesses are not shown in the drawings for convenience.

A recessed part 42p is formed in a central part in the left-right direction of the upper cover 42a of the second cover 42. The recessed part 42p is formed to extend in the front-back direction, and is formed at a position where the groove part 41b of the first cover 41 is extended forward. Due to the existence of the recessed part 42p, a step is formed on a surface of the second cover 42, thereby increasing the rigidity (particularly, bending rigidity) of the second cover 42. Although a member corresponding to the resin plate 43 of the first cover 41 is not fitted into the recessed part 42p, the above-mentioned member may be fitted therein.

### (3-3. Details of Power Supply Unit)

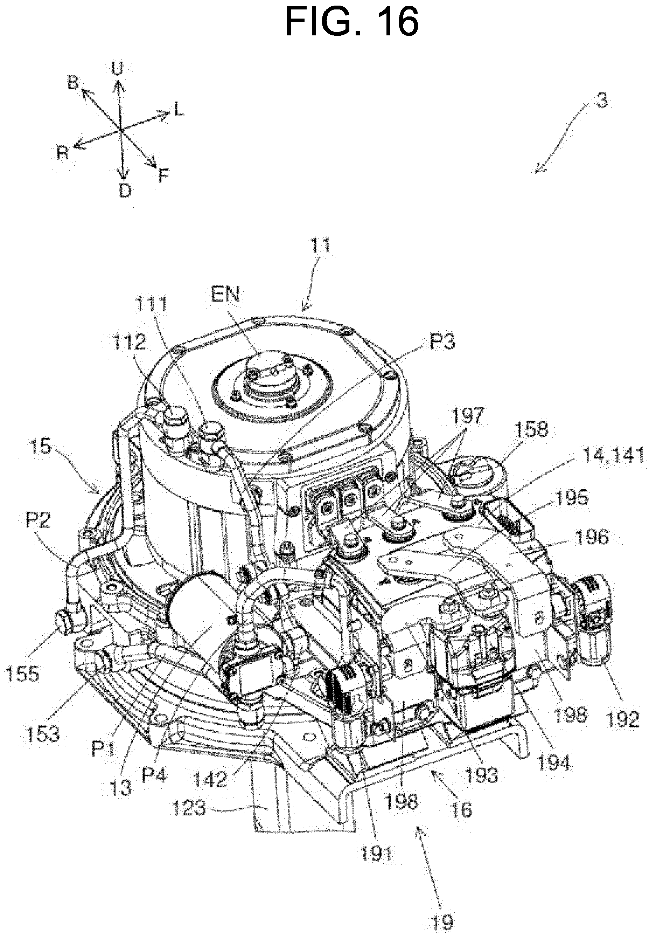

FIG. 16 is a perspective view showing a detailed configuration of the upper part of the electromotive sail drive 3 of the modification. In FIG. 16, illustrations of the above-described lid body 4 and support parts thereof (including the mounting stays 44, the side walls 45R and 45L, and the mounting cover 159) are omitted for convenience.

The electromotive sail drive 3 of the modification includes a power supply unit 19. The power supply unit 19 supplies electric power supplied from a battery (not shown) to the electromotive motor 11 via the motor control unit 14. Note that the power supply unit 19 shown in the electromotive sail drive 3 of the modification can of course be applied to the electromotive sail drive 3 shown above based on FIG. 2 and the like.

The power supply unit 19 includes a first connector 191, a second connector 192, a first conduction plate 193, a relay 194, a second conduction plate 195, a third conduction plate 196, and bus bars 197.

The first connector 191 and the second connector 192 are respectively positioned on the right front side and the left front side of the motor control unit 14, and each are mounted on the adapter 15 via a bracket 198. A DC voltage (for example, + 48V) is supplied from the battery to the first connector 191. The DC voltage is input to the relay 194 via the first conduction plate 193 made of copper. Inside the relay 194, ON/OFF of conduction is switched as necessary. When the conduction is ON, the DC voltage is input to the inverter 141b (see FIG. 4) of the motor control unit 14 via the second conduction plate 195 made of copper.

A DC voltage (for example, -48V) is supplied from the battery to the second connector 192. The DC voltage is input to the inverter 141b of the motor control unit 14 via the third conduction plate 196 made of copper.

In the inverter 141b, the DC voltage input via the second conduction plate 195 and the third conduction plate 196 is converted into three-phase (U phase, V phase, and W phase) AC voltage based on a control signal from the controller 141a (see FIG. 4). The AC voltage is supplied from the inverter 141b to the electromotive motor 11 via the bus bars 197 provided corresponding to the U phase, the V phase, and the W phase. Thus, the electromotive motor 11 is driven.

### [4. Supplement]

The controller 141a, while monitoring the temperatures of the electromotive motor 11 and motor control unit 14 which temperatures are the cool targets, may control the pump 13 to drive and stop. For example, it is allowed that the controller 141a should drive the pump 13 only when any one of or both of the electromotive motor 11 and the motor control unit 14 are hot (for example, a determination threshold or over and the limit temperature or below), and conversely, should stop the pump 13 when both are sufficiently cold (for example, below the determination threshold). The above control of the pump 13, when cooling of the electromotive motor 11 and the motor control unit 14 is not required, can prevent the power from being unnecessarily consumed by the driving of the pump 13. Further, driving the pump 13, especially when the electromotive motor 11 is in a stop state or at low RPM, causes the noise of the pump 13 to tend to be louder than the noise of the electromotive motor 11. Stopping the pump 13 when the electromotive motor 11 is in the stop state, etc. and the temperature of the electromotive motor 11 is low can reduce the noise of the pump 13.

In the present embodiment, it is so configured that the pump 13, the motor control unit 14, and the electromotive motor 11 are placed in series in the oil path through which the lubricant oil L flows, and the motor control unit 14 and the electromotive motor 11 are cooled in that order. In the above configuration, when some problem should occur to the circulation of the lubricant oil L and any of the electromotive motor 11 and the motor control unit 14 should become hotter than the determination threshold, the controller 141a may perform the following control on the electromotive motor 11, that is, a secondary control to make a shift to a limited operation mode, which limits the drive of the electromotive motor 11, so as to prevent further temperature rise of the electromotive motor 11, etc.

Further, in the oil path through which the lubricant oil L flows, the motor control unit 14 and the electromotive motor 11 may be placed in parallel. In this case, it may be allowed that sensors are provided in the respective oil paths of the motor control unit 14 and the electromotive motor 11, thereby to detect, in each of the oil paths, an error in the circulation of the lubricant oil L. In the above series placement, providing the above sensor at any one place in the oil path where the lubricant oil L flows makes it possible to detect the error in the circulation of the lubricant oil L, reducing the number of provided sensors than in the parallel placement.

The piping (first piping P1 to fourth piping P4) located in the oil path through which the lubricant oil L flows may be metal piping or may be resin piping (rubber piping). For example, since the pump 13 vibrates by being driven, it is desirable that the first piping P1 and the fourth piping P4 connected to the pump 13 are resin piping capable of absorbing the vibration rather than metal piping in which fatigue may occur due to vibration.

### [5. Appendices]

The electromotive sail drive and the ship which are described in the present embodiment can be expressed as described in the following appendices.

An electromotive sail drive of appendix (1) includes:
an electromotive motor;
a drive unit that is driven by the electromotive motor (that generates a propulsive force by being driven by the electromotive motor); and
a pump that circulates, via the electromotive motor, a lubricant oil inside the drive unit.

The electromotive sail drive of appendix (2), in the electromotive sail drive according to appendix (1), is such that
the electromotive motor has a motor cool oil path through which the lubricant oil flows.

The electromotive sail drive of appendix (3), in the electromotive sail drive according to appendix (1) or (2), further includes:
a motor control unit that controls the electromotive motor,
wherein
the pump circulates the lubricant oil via the motor control unit.

The electromotive sail drive of appendix (4), in the electromotive sail drive according to appendix (3), is such that
in an oil path where the lubricant oil flows from the drive unit toward the electromotive motor, the pump is positioned on an upstream side of the electromotive motor in a flow direction of the lubricant oil, and
the motor control unit is positioned between the pump and the electromotive motor.

The electromotive sail drive of appendix (5), in the electromotive sail drive according to appendix (3) or (4), is such that
the motor control unit includes an inverter that supplies power to the electromotive motor and a controller that controls the inverter.

The electromotive sail drive of appendix (6), in the electromotive sail drive according to appendix (5), wherein the motor control unit further includes a heat sink plate in which the inverter and the controller are placed, and the heat sink plate has a heat sink oil path through which the lubricant oil flows.

The electromotive sail drive of appendix (7), in the electromotive sail drive according to any of appendices (3) to (6), further includes:
an adapter that is mounted to the drive unit,
wherein
the electromotive motor, the motor control unit, and the pump are installed on the adapter.

The electromotive sail drive of appendix (8), in the electromotive sail drive according to appendix (7), is such that
the drive unit has an oil chamber that houses the lubricant oil, and
the adapter has:
   a first connection port that is connected via a first piping with the pump,
   a connection pipe that connects the first connection port with the oil chamber,
   a second connection port that is connected via a second piping with the electromotive motor, and
   a lubricant oil receiving unit that communicates with the second connection port, and that communicates with the oil chamber.

The electromotive sail drive of appendix (9), in the electromotive sail drive according to appendix (8), is such that
in the adapter, the lubricant oil is received in a part of the lubricant oil receiving unit.

The electromotive sail drive of appendix (10), in the electromotive sail drive according to appendix (8) or (9), is such that
the drive unit further has:
a water path partitioned from the oil chamber,
wherein
the water path connects with an intake port of seawater.

The electromotive sail drive of appendix (11), in the electromotive sail drive according to any of appendix (8) to (10), is such that
the adapter has an oil supply port that communicates with the lubricant oil receiving unit.

A ship of appendix (12) includes the electromotive sail drive according to any of appendices (1) to (11).

Although the embodiment of the present invention has been described above, the scope of the present invention is, however, not limited thereto, and can be carried out within an extended or modified range without departing from the gist of the present invention.

### INDUSTRIAL APPLICABILITY

The electromotive sail drive of the invention can be used for a ship, for example, a sail ship.

### REFERENCE SIGNS LIST

1 ship
3 electromotive sail drive
11 electromotive motor
12 drive unit
12R oil chamber
12W water path
13 pump
14 motor control unit
15 adapter
113 motor cool oil path
123a passing water port (intake port)
123b communication hole (intake port)
141a controller
141b inverter
142 heat sink plate
143 heat sink oil path
153 first connection port
154 connection pipe
155 second connection port
156 lubricant oil receiving unit
158 oil supply port
L lubricant oil

## Claims

1. An electromotive sail drive comprising:
an electromotive motor;
a drive unit that is driven by the electromotive motor; and
a pump that circulates, via the electromotive motor, a lubricant oil inside the drive unit.

2. The electromotive sail drive according to claim 1, wherein the electromotive motor has a motor cool oil path through which the lubricant oil flows.

3. The electromotive sail drive according to claim 1, further comprising:
a motor control unit that controls the electromotive motor,
wherein
the pump circulates the lubricant oil via the motor control unit.

4. The electromotive sail drive according to claim 3, wherein in an oil path where the lubricant oil flows from the drive unit toward the electromotive motor, the pump is positioned on an upstream side of the electromotive motor in a flow direction of the lubricant oil, and the motor control unit is positioned between the pump and the electromotive motor.

5. The electromotive sail drive according to claim 3, wherein the motor control unit includes an inverter that supplies power to the electromotive motor and a controller that controls the inverter.

6. The electromotive sail drive according to claim 5, wherein
the motor control unit further includes a heat sink plate in which the inverter and the controller are placed, and
the heat sink plate has a heat sink oil path through which the lubricant oil flows.

7. The electromotive sail drive according to claim 3, further comprising:
an adapter that is mounted to the drive unit,
wherein
the electromotive motor, the motor control unit, and the pump are installed on the adapter.

8. The electromotive sail drive according to claim 7, wherein the drive unit has an oil chamber that houses the lubricant oil, and
the adapter has:
a first connection port that is connected via a first piping with the pump,
a connection pipe that connects the first connection port with the oil chamber,
a second connection port that is connected via a second piping with the electromotive motor, and
a lubricant oil receiving unit that communicates with the second connection port, and that communicates with the oil chamber.

9. The electromotive sail drive according to claim 8, wherein in the adapter, the lubricant oil is received in a part of the lubricant oil receiving unit.

10. The electromotive sail drive according to claim 8, wherein
the drive unit further has:
a water path partitioned from the oil chamber,
wherein
the water path connects with an intake port of seawater.

11. The electromotive sail drive according to claim 8, wherein the adapter has an oil supply port that communicates with the lubricant oil receiving unit.

12. A ship comprising the electromotive sail drive according to any of claims 1 to 11.
